# EUROPÄISCHE PATENTSCHRIFT

(11) **EP 0 368 142 B1**
(45) Veröffentlichungstag und Bekanntmachung des Hinweises auf die Patenterteilung: **06.07.1994**
(21) Anmeldenummer: 89120279.8
(22) Anmeldetag: 02.11.1989
(51) Int. Cl.: F02P 3/04, H01L 23/40, H01L 23/48, F02P 5/145

(54) **Elektronisches Steuergerät**
Electronic control apparatus
Dispositif de commande électronique

(30) Priorität: 09.11.1988 DE 3837974
(43) Veröffentlichungstag der Anmeldung: 16.05.1990
(73) Patentinhaber: TEMIC TELEFUNKEN microelectronic GmbH, 74072 Heilbronn (DE)
(72) Erfinder: Niemetz, Linhard, D-8540 Rednitzhembach (DE)
(74) Vertreter: Maute, Hans-Jürgen, Dipl.-Ing.

(56) Entgegenhaltungen:
- EP-A- 0 093 029
- EP-A- 0 098 028
- DE-A- 2 804 292
- DE-A- 3 604 074
- DE-U- 8 715 073
- US-A- 4 471 314

## Beschreibung

Die Erfindung betrifft ein elektronisches Steuergerät nach dem Oberbegriff des Anspruchs 1.

Ein solches Steuergerät ist z.B. aus DE-U-8715073 bekannt.

Viele elektronische Steuergeräte, die beispielsweise als Zündsteuergerät bei Transistorzündungen in Dickschichttechnik eingesetzt werden, besitzen als wesentliche Bestandteile eine elektronische Schaltung, einen Kühlkörper und ein Gehäuse mit Kunststoffrahmen.
Die elektronische Schaltung enthält meist eine oder mehrere Hybridschaltungen und befindet sich auf der Oberseite einer keramischen Trägerplatte, durch die sie vom Kühlkörper elektrisch isoliert ist.
Der Gehäuserahmen aus Kunststoff, in dem eine Metallplatine integriert ist, wird durch Nieten am Kühlkörper befestigt, wobei die Niet bei der Gehäusemontage des Zündsteuergeräts separat eingelegt werden muß. Die Metallplatine ist über Bonddrähte mit der elektronischen Schaltung verbunden und dient als externe Steckerverbindung; unter anderem wird dadurch eine Verbindung des Massepunkts der Hybridschaltung mit dem Masseanschluß des Steckers hergestellt.
Zusätzlich zu der Masseverbindung Hybridschaltung-Stecker besitzen die meisten elektronischen Steuergeräte eine Bondverbindung von der Hybridschaltung zum Kühlkörper, womit die Elektronikmasse der Hybridschaltung mit dem Kühlkörper möglichst niederohmig verbunden wird.

Die elektrische Verbindung zwischen der Masse der elektronischen Schaltung und dem Kühlkörper erhöht die sogenannte elektromagnetische Verträglichkeit des Steuergeräts, d.h. sie verbessert den Schutz des Steuergeräts vor externen eingestreuten Störungen, beispielsweise hochfrequenten Einstrahlungen.
Diese zusätzliche Masseverbindung muß im Fehlerfall, d.h. wenn der Masseanschluß des Steckers bricht oder hochohmig wird, den Arbeitsstrom des Steuergeräts, bei Zündsteuergeräten beispielsweise 7,5 A, über den Weg Massebond-Kühlkörper- Montageblech ableiten und daher ausreichend fest für diesen Strom sein. Außerdem muß das Hybrid-Layout ein solches Design besitzen, daß der geänderte Stromweg zu keiner Masseverkopplung in der elektronischen Schaltung führt und somit die Funktion des Steuergerätes nicht beeinträchtigt wird. Darüber hinaus muß die zusätzliche Masseverbindung vom elektrisch zentralen Massepunkt der Schaltung ausgehen, damit bei geänderten Betriebsbedingungen keine Fehlfunktionen des Steuergeräts auftreten.

Diese Anforderungen an die Masse-Bondverbindung können oft nur sehr schwierig realisiert werden und haben einen erhöhten Platzbedarf sowohl auf der Hybridschaltung als auch auf dem Kühlkörper und zusätzliche Kreuzungen auf der Hybridschaltung zur Folge.
Bei der Montage des elektronischen Steuergeräts ist ein zusätzlicher Bondvorgang von der Hybridschaltung zum Kühlkörper vonnöten, wobei überdies die Gußhaut an der Stelle, wo der Bond auf den Kühlkörper gesetzt wird, extra abgeschliffen werden muß.

Der Erfindung liegt die Aufgabe zugrunde, den Montageaufwand und die Herstellungskosten von elektronischen Steuergeräten, insbesondere von Zündsteuergeräten, zu reduzieren und ein Steuergerät anzugeben, das ohne zusätzliche Masse-Bondverbindung zwischen Hybridschaltung und Kühlkörper auskommt.

Dies wird erfindungsgemäß dadurch erreicht, daß die Masseverbindung zwischen Hybridschaltung und Steckeranschluß über im Kunststoff-Gehäusekörper enthaltene, elektrisch leitende Teile mit dem Kühlkörper verbunden ist.

Vorteilhafte Ausgestaltungen der Erfindung ergeben sich aus den Unteransprüchen.

Dadurch, daß die Masseverbindung über die im Gehäusekörper integrierte Metallplatine hergestellt wird, ist keine zusätzliche elektrische Verbindung zwischen Hybridschaltung und Kühlkörper erforderlich.
Es ist daher ein einfacheres Layout mit nur einem Strompfad ohne zusätzlichen Massefleck möglich, wodurch der Platzbedarf auf Hybridschaltung und Kühlkörper verringert wird.
Eine Reduzierung des Montageaufwands wird neben dem Wegfall des zusätzlichen Bondvorgangs auch dadurch erreicht, daß ein Einlegen der Nieten bei der Gehäusemontage bzw. beim Gehäusespritzen entfällt, da die Nieten bereits in der Metallplatine integriert sind.

Die Erfindung soll nun nachstehend anhand des Beispiels eines Zündsteuergeräts beschrieben werden. Es zeigen:
- Figur 1: In Draufsicht den Aufbau eines Zündsteuergeräts.
- Figur 2: Das Zündsteuergerät im Schnitt gemäß der Linie A-A in Figur 1.

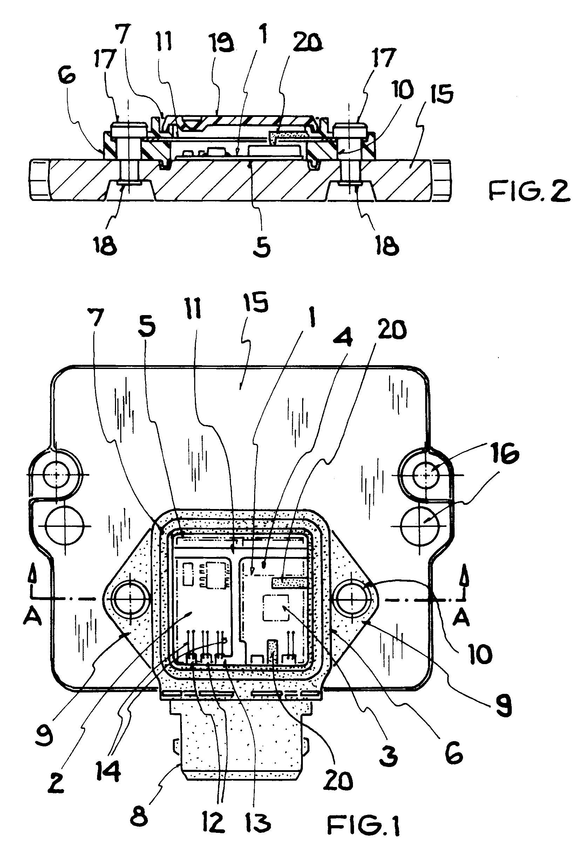

Gemäß Figur 1 und 2 enthält das Zündsteuergerät einen Kühlkörper 15, einen Gehäusekörper 6 mit Kunststoffrahmen 7, Steckeranschlußbuchse 8 und Deckel 19, sowie eine elektronische Zündschaltung 1.

Die elektronische Schaltung 1 befindet sich auf einem meist keramischen Trägerkörper 5, der zur elektrischen Isolierung der elektronischen Schaltung 1 vom Kühlkörper 15 dient. Die wesentlichen Komponenten der elektronischen Zündschaltung 1 sind das Steuerteil 2, das Leistungsteil 3, und eine RC-Kombination 4.

Im Kunststoff-Gehäusekörper 6 ist eine Metallplatine 11 integriert, deren Steckeranschlüsse 12, 13 über Bonddrähte 14 mit der elektronischen Schaltung 1 verbunden sind. Die Metallplatine 11 dient somit zur Kontaktierung der elektronischen Schaltung 1 und stellt eine externe Anschlußmöglichkeit des Zündsteuergeräts über die Steckeranschlußbuchse 8 her.
Die Löcher 10 im flanschförmigen Teil 9 des Kunststoffrahmens 7 werden bei der Befestigung des Rahmens 7 auf dem Kühlkörper 15 verwendet. Die Löcher 16 im Kühlkörper dienen zur Montage des Zündsteuergeräts auf einem Blech im Motorraum des Kraftfahrzeugs.
Über die im Gehäuserahmen 7 integrierten Andrückelemente 20 wird die elektronische Schaltung 1 während der Montage definiert gegen den Kühlkörper 15 gepreßt.

Das Herstellungsverfahren der im Gehäusekörper integrierten Masseverbindung zum Kühlkörper und deren Wirkungsweise wird nun nachstehend anhand eines Ausführungsbeispiels erläutert.
Die Metallplatine 11 ist beispielsweise ein Stanzteil aus CuSn₆, das durch entsprechende Oberflächenbehandlung veredelt wurde. Sie besitzt zwei Löcher 10, in die beispielsweise zwei Aluminiumnieten 17 eingepreßt werden, die eine elektrische Verbindung zur Metallplatine 11 besitzen.
Nachdem die Metallplatine 11 mit Kunststoff zur Bildung des Gehäusekörpers 6 umspritzt wurde, ragen an der Unterseite des flanschförmigen Teils 9 des Kunststoffrahmens 7 die zwei Nieten 17 heraus. Bei der Montage des Kunststoffrahmens 7 auf dem Kühlkörper 15 werden die Nieten 17 durch zwei Löcher im Kühlkörper geführt und an der Unterseite des Kühlkörpers 15 vernietet. Durch die Nietung 18 am Kühlkörper wird zum einen der Kunststoffrahmen 7 und damit der gesamte Gehäusekörper 6 am Kühlkörper 15 befestigt, zum anderen eine elektrische Verbindung zwischen Niet 17 und Kühlkörper 15 hergestellt.

Nachdem das Steuerteil 2 der elektronischen Schaltung mit den Steckeranschlüssen 12, 13 der Metallplatine elektrisch verbunden wurde, beispielsweise mittels Bonddrähten 14, ist auch der Kühlkörper über den Pfad Niet-Metallplatine-Bonddraht, gemäß Figur 1 über den Anschluß 13, elektrisch mit der Masse der Hybridschaltung verbunden.

Neben der Verwendung in Zündsteuergeräten läßt sich die integrierte Masseverbindung beispielsweise auch bei elektronischen Einspritzanlagen o.ä. elektronischen Steuergeräten einsetzen, bei denen verschiedene Baugruppen der elektronischen Schaltung, die auf einem Kühlkörper angebracht werden müssen, in Hybridtechnik ausgebildet sind.

## Patentansprüche

1. Elektronisches Steuergerät, insbesondere Zündsteuergerät, bestehend aus einer elektronischen Schaltung (1) in Form einer Hybridschaltung, die auf einem Kühlkörper (15) angeordnet ist, sowie aus einem die Steckeranschlulßbuchse (8) enthaltenden Kunststoff-Gehäusekörper (6), wobei eine Verbindung (14) zwischen dem Masseanschluß der Hybridschaltung und einem Steckeranschluß (13) besteht, dadurch gekennzeichnet, daß die Masseverbindung zwischen Hybridschaltung und Steckeranschluß (13) über im Kunststoff-Gehäusekörper (6) enthaltene, elektrisch leitende Teile (11) mit dem Kühlkörper (15) verbunden ist.

2. Elektronisches Steuergerät nach Anspruch 1, dadurch gekennzeichnet, daß der Kunststoff-Gehäusekörper (6) aus einem rahmenförmigen Teil (7) und der Steckeranschlußbuchse (8) besteht, daß der rahmenförmige Teil (7) flanschförmige Teile (9) aufweist, die Durchgangsöffnungen (10) zur Aufnahme von Befestigungsmitteln (17) am Kühlkörper (15) enthalten, und daß im Kunststoffrahmen (7) eine sich in die Steckeranschlußbuchse (8) erstreckende Metallplatine (11) angeordnet ist, die den Masse-Steckeranschluß (13) mit den Durchgangsöffnungen (10) verbindet.

3. Elektronisches Steuergerät nach Anspruch 2, dadurch gekennzeichnet, daß die Durchgangsöffnungen (10) Schrauben oder Nieten (17) enthalten, durch die der Kunststoff-Gehäusekörper (6) mechanisch fest mit dem Kühlkörper (15) verbunden ist und die zugleich die elektrische Verbindung zwischen Metallplatine (11) und Kühlkörper (15) herstellen.

4. Elektronisches Steuergerät nach Anspruch 3, dadurch gekennzeichnet, daß die Schrauben oder Nieten (17) aus einem Metall mit guter elektrischer Leitfähigkeit, beispielsweise Aluminium bestehen.

5. Verfahren zur Herstellung eines elektronisches Steuergeräts nach einem der Ansprüche 2 bis 4, dadurch gekennzeichnet, daß die Metallplatine (11) mit den Steckeranschlüssen (12, 13) und den Durchgangsöffnungen (10), welche die Befestigungsmittel (17) enthalten, zur Bildung des rahmenförmigen Teils (7) und der Steckeranschlußbuchse (8) des Gehäusekörpers (6) derart mit Kunststoff umspritzt wird, daß die Befestigungsmittel (17) an der Unterseite des Kunststoff-Gehäusekörpers (6) herausragen.

## Claims

1. An electronic control device, in particular an ignition control device, comprising an electronic circuit (1) in the form of a hybrid circuit which is arranged on a cooling body (15) and comprising a synthetic resin housing body (6) containing the plug connection socket (8), wherein a connection (14) exists between the earth terminal of the hybrid circuit and a plug terminal (13), characterised in that the earth connection between the hybrid circuit and the plug terminal (13) is connected to the cooling body (15) via electrically conductive parts (11) contained in the synthetic resin housing body (6).

2. An electronic control device as claimed in Claim 1, characterised in that the synthetic resin housing body (6) consists of a frame-like part (7) and the plug connection socket (8), that the frame-like part (7) comprises flange-like parts (9) which contain holes (10) for the accommodation of fixing means (17) of the cooling body (15), and that in the synthetic resin frame (7) there is arranged a metal plate (11) which extends into the plug connection socket (8) and which connects the earth plug terminal (13) to the holes (10).

3. An electronic control device as claimed in Claim 2, characterised in that the holes (10) contain screws or rivets (17) by which the synthetic resin housing body (6) is connected in a mechanically stable fashion to the cooling body (15) and which simultaneously establish the electric connection between the metal plate (11) and the cooling body (15).

4. An electronic control device as claimed in Claim 3, characterised in that the screws or rivets (17) consist of a metal with good electric conductivity, for example aluminium.

5. A process for the production of an electronic control device as claimed in one of Claims 2 to 4, characterised in that for the formation of the frame-like part (7) and the plug connection socket (8) of the housing body (6), the metal plate (11), together with the plug terminals (12, 13) and the holes (10) which contain the fixing means (17), is extrusion-coated with synthetic resin in such manner that the fixing means (17) project from the underneath of the synthetic resin housing body (6).

## Revendications

1. Appareil de commande électronique, en particulier appareil de commande d'allumage, comprenant un circuit électronique (1) sous la forme d'un circuit hybride, qui est disposé sur un radiateur (15), ainsi qu'un corps de boîtier (6) en matière plastique comportant un manchon de connecteur à enfichage (8), de même qu'une liaison (14) entre la borne de masse du circuit hybride et une borne de connecteur (13), caractérisé en ce que la liaison pour la masse entre le circuit hybride et la borne de connecteur (13) est raccordée au radiateur (15) à travers des pièces (11) électriquement conductrices contenues dans le corps de boîtier (6) en matière plastique.

2. Appareil de commande électronique selon la revendication 1, caractérisé en ce que le corps de boîtier (6) en matière plastique est constitué d'une partie (7) ayant la forme d'un encadrement et du manchon de connecteur (8), que la partie (7) en forme d'encadrement comporte des parties (9) en forme de pattes qui présentent des ouvertures traversantes (10) pour recevoir des moyens (17) servant à la fixation au radiateur (15) et qu'une plaque métallique (11), s'étendant dans le manchon de connecteur (8), relie la borne de connecteur (13) pour la masse aux ouvertures traversantes (10).

3. Appareil de commande électronique selon la revendication 2, caractérisé en ce que les ouvertures traversantes (10) contiennent des vis ou des rivets (17) par lesquels le corps de boîtier (6) en matière plastique est relié mécaniquement de façon rigide au radiateur (15) et qui établissent en même temps la liaison électrique entre la plaque métallique (11) et le radiateur (15).

4. Appareil de commande électronique selon la revendication 3, caractérisé en ce que les vis ou les rivets (17) sont faits d'un métal de bonne conductibilité électrique, d'aluminium par exemple.

5. Procédé pour réaliser un appareil de commande électronique selon une des revendications 2 à 4, caractérisé en ce que, pour la formation de la partie (7) en forme d'encadrement et du manchon de connecteur (8) du corps de boîtier (6), la plaque métallique (11) avec les bornes de connecteur (12, 13) et les ouvertures traversantes (10), lesquelles contiennent les moyens de fixation (17), sont surmoulées avec de la matière plastique, de manière que les moyens de fixation (17) dépassent sur le côté inférieur du corps de boîtier (6) en matière plastique.
